# EUROPEAN PATENT SPECIFICATION

(11) **EP 0 348 783 B1**
(45) Date of publication and mention of the grant of the patent: **11.10.1995**
(21) Application number: 89111111.4
(22) Date of filing: 19.06.1989
(51) Int. Cl.: H01L 21/302, C30B 31/00, B28D 5/02

(54) **Process of making discrete type substrates**
Verfahren zur Herstellung von Einzelsubstraten
Procédé pour la fabrication de substrats individuels

(30) Priority: 28.06.1988 JP 162043/88
(43) Date of publication of application: 03.01.1990
(73) Proprietor: NAOETSU ELECTRONICS COMPANY, Nakakubiki-gun Niigata-Ken (JP)
(72) Inventor: Satoh, Tsutomu, Jyoetsu-shi Niigata-ken (JP); Nishimaki, Kouichi, Higashi-Kubiki-gun Niigata-ken (JP); Endoh, Shin-Ichi, Jyoetsu-shi Niigata-ken (JP); Kurokawa, Toyoharu, Jyoetsu-shi Niigata-ken (JP)
(74) Representative: Denmark, James

(56) References cited:
- EP-A- 0 244 202
- EP-A- 0 253 162
- CH-A- 407 337
- FR-A- 2 590 879
- US-A- 3 936 328

## Description

### BACKGROUND OF THE INVENTION

### (Field of the Invention)

This invention relates to a process for making a substrate made from a monolithic silicon wafer, and more particularly a substrate of a discrete element for use in a transistor, diode or the like.

### (Description of the Prior Art)

It is known that a substrate made from a single crystal Si-wafer (silicon wafer) may be used for various types of discrete elements such as a transistor, a pn-junction and the like.

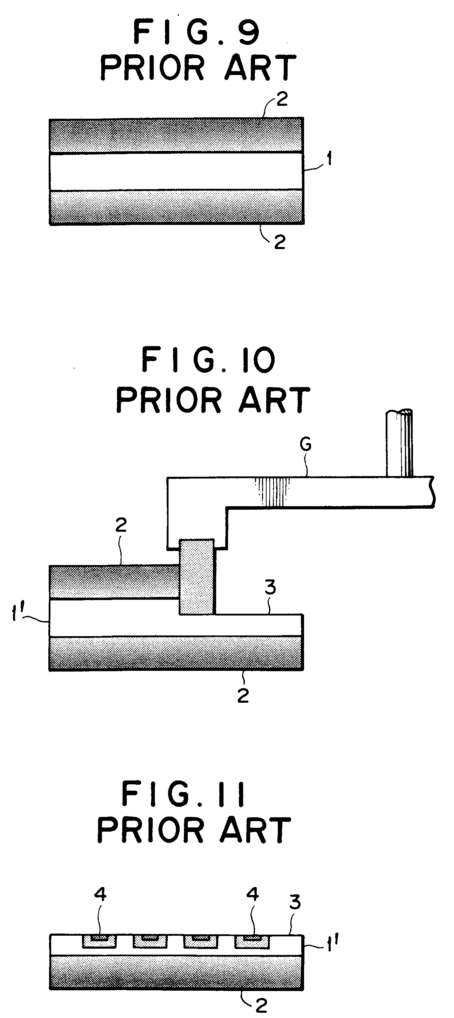

A processing method is shown schematically in Figs. 9 to 11, in which a wafer (1) is sliced from an Si-ingot by a slicing saw having a blade bonded with abrasive grains such as industrial diamonds or the like, and then transferred to a thermal diffusion furnace for the doping of impurity diffused layers (2) onto its two sides, P(phosphor), B(boron) or the like being the impurity compositions.

A technical problem in the above doping process, however, is that the wafer (1) having the impurity diffused layers (2) on both sides is subjected to a grinding process and one side is ground by grinding machine to remove its impurity layer in order to obtain a plain surface (3). This problematic aspect is shown schematically in Fig. 10 wherein reference mark (G) shows a grinding machine. This grinding process prepares the wafer for doping with a further impurity diffused layer (4) on the plain surface (3) to provide a transistor such as a bipolar transistor doped with an emitter and a base by way of preparatory processes such as etching, polishing and the like. After completion of the doping of new impurities (4) in the plain surface (3), the wafer, shown schematically in Fig. 11, undergoes a wiring stage to form a die.

In the above-described conventional process, since one side of the wafer (1) must be ground to provide a wafer having a plain surface (3) on one side and an impurity diffused layer (2) on the other side, the problem is obvious in that valuable silicon material is wasted as grind loss along with one of the impurity diffused layers made in the first doping.

According to a prior art document, the provisional publication of Japanese Patent Application JP-A-1 030 715, it is disclosed that a silicon block consisting of a plurality of silicon wafers, stacked and bonded together so as to shape something like a Si-ingot, is sliced by an ID saw gradually at a predetermined thickness.

In this prior art, despite the wafer being sliced with a predetermined thickness, the sliced wafer is formed as two pieces of wafer which are adequately bonded, but not a solid wafer. In addition, prior to the slicing process, the wafer does not have impurity diffusion layers on both sides. Therefore, it is clear that this prior art teaches a process for making a substrate of a pn-junction type element with a sintered layer sandwiched between two pieces of different kinds of wafer.

Accordingly, in the provisional publication of Japanese Patent Application JP-A-1 030 715, one cannot recognize any disclosure of a process for making a substrate having an impurity diffused layer on one side and a plain surface without any impurity diffused layer on the other side of the Si-wafer. These features will be described later as a characteristics of the present invention.

In comparison of both processes, in the prior art of the provisional publication of Japanese Patent Application No JP-A-1 030 715 only one piece of substrate for a pn-junction element is obtained from two pieces of wafer or two substrates of pn-junction elements are obtained from three pieces of wafer.

In contrast, the present invention provides four pieces of substrate of pn-junction element from two pieces of wafer as well as six substrates of pn-junction element from three pieces of wafer, thus the technical object of the present invention is quite different from the above prior art.

### SUMMARY OF THE INVENTION

The present invention, therefore, has been achieved to solve the aforementioned technical problem, and it is a general object of this invention to provide a process for making a substrate of a discrete element, which prevents the waste accompanying the removal and loss of the impurity diffusion layer including its silicon material.

It is a further object of this invention to provide a process for re-slicing a wafer simply.

It is another object of this invention to provide an improved process for making the substrate, thus enabling higher grade products.

According to the present invention, there is provided a process of making semiconductor wafer substrates, as defined in claim 1.

The process may be applied for making semiconductor wafer substrates from a wafer having impurity diffusion surface layers on the sides thereof and a core into which the impurity diffusion layers do not extend, characterised by the steps of:
bonding a slice base to an edge of said wafer;
holding one side of said wafer by a vacuum action;
loading said wafer into a slicing machine comprising a rotatable slicing saw;
slicing said wafer from an edge opposite to said slice base to form two wafer substrates of each of which one side has an impurity diffusion layer and the other side presents an impurity diffusion-free surface suitable for doping; and
holding an opposed side of said wafer at least prior to completion of the slicing of said slice base.

The impurity of said impurity diffused layers preferably consists of one or more of P(phosphor), B(boron), Al(aluminium), Ga(gallium), As(arsenic) and Sb(antimony).

Preferably, the said wafer is sliced through its centre to form wafer substrates of substantially equal thickness. The said wafer may be a silicon wafer with an approximate thickness of between 0.9 mm and 1.1 mm.

Alternatively, one side only of said wafer may be held during slicing of the said wafer, the saw blade cutting only partially into said slice base so as to maintain the attachment of the wafer substrates after the completion of slicing.

The said wafer may be between 5 cm and 15 cm in diameter, and furthermore the thickness of each substrate may be between approximately 200 um and 350 um.

The process preferably further comprises the step of forming the plain surfaces of said wafer substrates to be suitable for doping a new impurity diffusion layers.

### BRIEF DESCRIPTION OF THE DRAWINGS

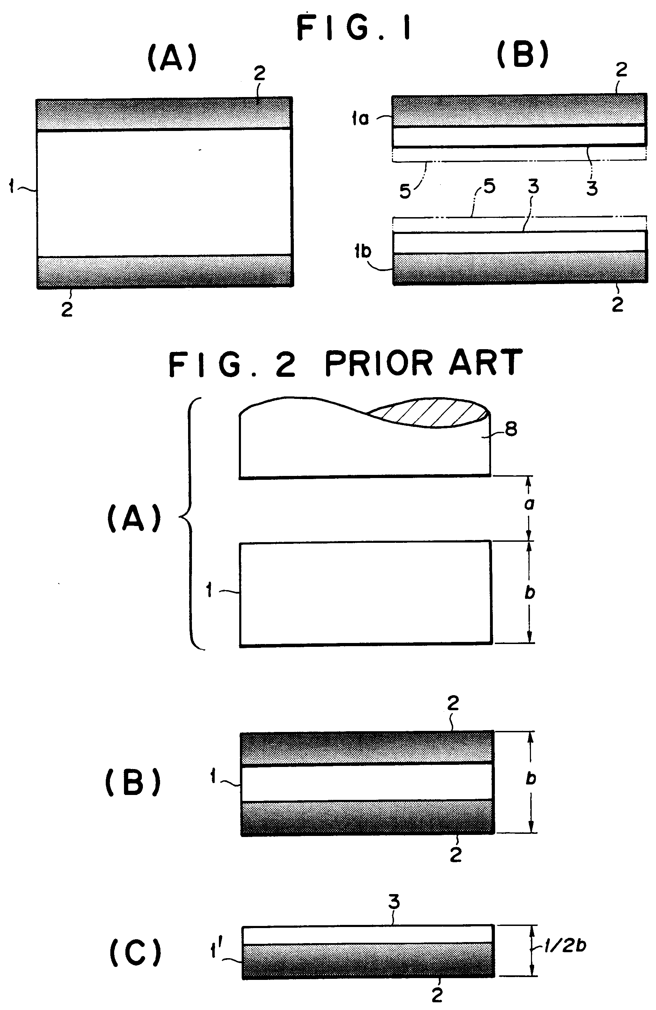

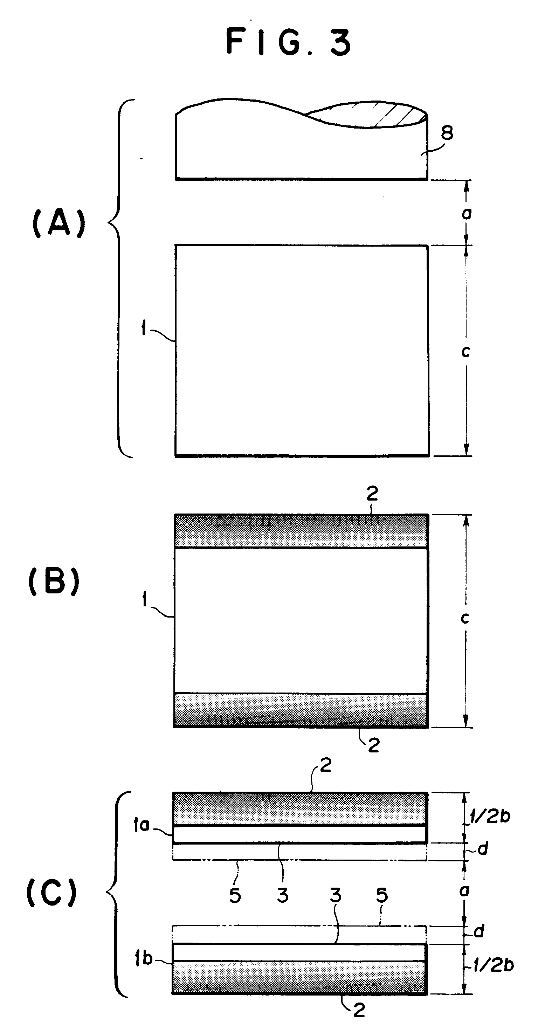

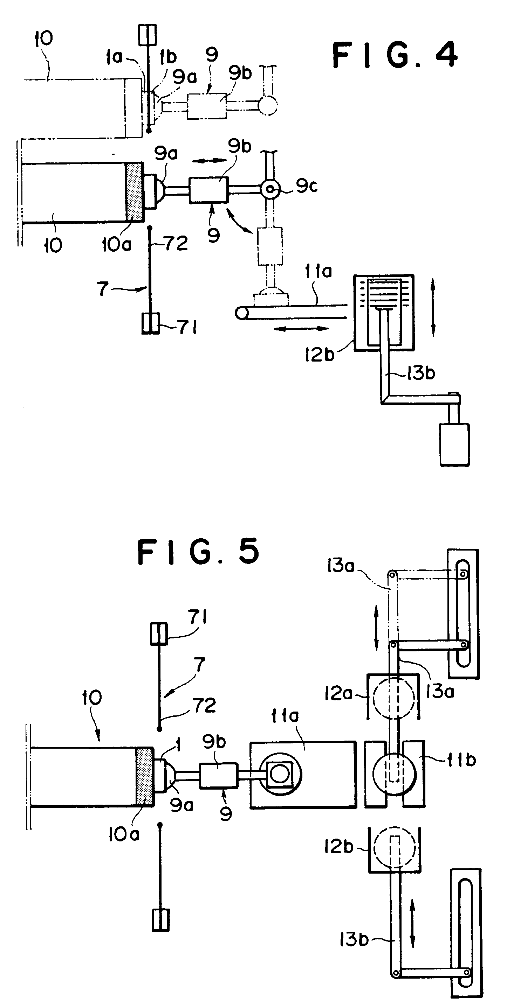

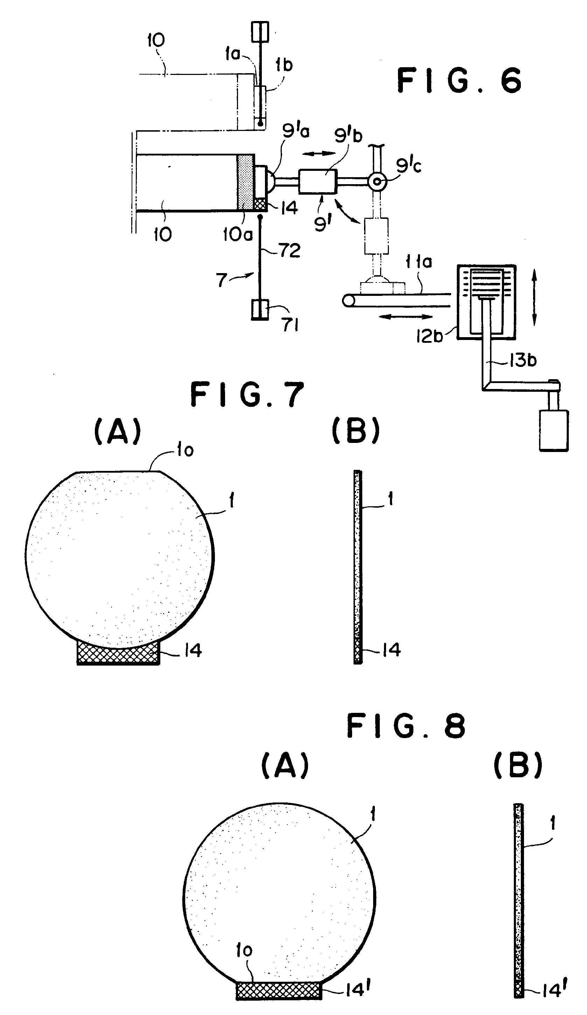

Fig. 1(A) and Fig. 1(B) are sectional views showing the basis of the technical means of the process for re-slicing a wafer in the present invention, Fig. 2 is a sectional view showing the amount of grind loss from one side of the wafer in one case of prior art, Figs. 3(A), (B) and (C) are sectional views for showing the present invention in comparison with the prior art, Figs. 4 to 6 show apparatus not forming part of the present invention. Fig. 7(A) is a front elevation showing a fixing position and structure of a slice base to fix the wafer in the method according to the present invention, Fig. 7(B) is a side view of Fig. 7(A), Fig. 8(A) is a front elevation showing a fixing position and structure of a slice base to fix the wafer of another practical example, Fig. 8(B) is a side elevation of Fig. 8(A) and Fig. 9 to Fig. 11 are sectional views showing a process of the prior art.

### DESCRIPTION OF THE PREFERRED EMBODIMENT

As the gist of the present invention, the process of this invention comprises of providing a semiconductor wafer which has an impurity diffusion layer on both sides but no impurity diffusion layer within its core portion, wherein re-slicing the wafer into two pieces at approximately the centre of the thickness of wafer or at precisely its centre so as to make each re-sliced surface a plain surface to enable further doping.

In Fig. 1(A), a wafer (1) has impurity diffusion layers (2) on both sides but none in the core portion (1), which means that the thickness of the wafer (1) consists of (1)+(2)+(2) as marked in Fig. 1(A). This is the form in which the wafer (1) is initially provided in the process of the present invention.

If Fig. 1(B), the wafer (1) has been re-sliced into two pieces as shown in the marks (1a) and (1b) at approximately the centre of the wafer (1) so as to make the sliced surfaces plain surfaces (5), shown by double dot broken lines in Fig. 1(B), which are called "as-cut wafer" surfaces in the art, enabling further doping and certain other necessary processes such as polishing, etching, thermally treating and inspection processes. These necessary processes, shown schematically between the referential numbers (5) and (3), cause a substantial loss in thickness, in addition to kerf-loss occurring during slicing. As to the material of wafer (1), it is made from a monolithic silicon ingot which measures between approximately 5cm to approximately 15cm in diameter, it will however be appreciated that other diameters are also possible.

The impurity diffusion layer (2) consists of P(phosphor), B(boron), Al(aluminium), Ga(gallium), As(arsenic), Sb(antimony) and/or the like.

In Fig. 2 and Fig. 3, according to the above re-slicing process in Figs. 1(A) and (B), it is noted that the impurity diffusion layers (2) on both sides are utilized intact, thus two pieces of substrate (1a)(1b) for producing a discrete element are obtainable from one piece of wafer (1) with an impurity diffusion layer (2) upon each side respectively, and as a result neither is a impurity diffusion layer removed, nor is silicon material wasted from the wafer (1), thus the impurity diffusion layers (2) are saved intact as they were. The disadvantages involved in the conventional method are shown schematically with reference to Fig. 2 (conventional method) and Fig. 3 (the present invention).

Conventionally, as shown in Fig. 2(A), a wafer (1) of thickness (b) is initially sliced from a Si-ingot (8) with an accompanying kerf-loss (a), and impurity diffusion layers (2) and (2) are formed on both sides by doping processes as shown in Fig. 2(B). Now assuming that the thickness (b) does not change substantially during the processes of polishing and the like because of the very small amount of loss occurring during polishing after the completion of doping the impurity diffusion layers (2)(2) onto its two sides, it becomes clear that half the thickness (¹/₂b) of the wafer (1) has been lost during the subsequent grinding process for removing one of the impurity diffusion layer (2) in Fig. 2. This process is shown in Fig. 10. Thus, it means that an amount of silicon material amounting to the kerf-loss (a) plus the grinding loss (¹/₂b) has been lost in order to obtain one piece of substrate having a thickness (¹/₂b) for making a discrete element in the conventional method.

In contrast, according to the present invention in Fig. 3(A), a wafer (1) having a thickness (c) is sliced from an Si-ingot (8) with an accompanying kerf-loss (a). In Fig. 3(B), it shows a wafer (1) having impurity diffusion layers (2) on both sides.

In Fig. 3(C), it shows a state at which the wafer (1) has been re-sliced into two pieces of substrate (1a)(1b). In this drawing, the referential mark (a) is the kerf-loss when re-sliced, which should be the same as the initial kerf-loss during slicing from the Si-ingot (8), the mark (d) illustrates the polishing loss (which is in fact negligible) and the mark (¹/₂b) is the thickness of substrate (1a) or (1b). From this relationship between them, the thickness (c) consists of the followings: (c) = (¹/₂b) + (¹/₂b) + (d) + (d) + (a). From this, it becomes clear that the amount of ¹/₂[(a)+(a)+(d)+(d)]=[(a)+(d)] of Si-material will be lost in order to obtain one piece of discrete element (1a) or (1b) which having a thickness (¹/₂b).

In the above loss, that is, [(a)+(d)], however, the (d)-value is negligible. In contrast, the conventional loss is [(a)+(¹/₂b)] per piece of substrate (1a)(1b). According to this comparison, therefore, it is obvious how much this invention can save not only of the Si-material per se but also in manufacturing effort. With respect to the specification in practice as to the thickness of wafer (1), it is noted that the thickness is approximatley 0.9 mm to 1.1 mm (millimeter) per piece and also the thickness of substrate (1a)(1b) is approximately 200 um to 350 um (micron ie 0.2 mm to 0.35 mm) per piece after the completion of all necessary processing.

Referring now in detail to the procedure according to the present invention, initially a wafer (1) is provided from a Si-ingot (8) with the necessary thickness (c) for later re-slicing, after which it is treated by doping impurity diffusion layers on both sides by way of the other various processes as described previously, whereafter it is transferred to the re-slicing stage which is the highlight of the present invention. The transportation is performed by the so-called "cassette load wafer transfer system" and the insertion of the unprocessed wafer (1) is performed by the so-called "cassette insertion system" in combination with a "single wafer transfer system".

Figs. 4 and 5 show the abovementioned cassette insertion system in combination with a single wafer transfer system for a re-slicing system. These systems are defined and designated in whole as a "re-slicing apparatus" in this disclosure. Although not illustrated in Figs. 4 and 5, an element of the invention is that of a slice base which is bonded to an edge of the wafer as illustrated in Figs. 7 and 8.

Basically, the re-slicing apparatus comprises of four mechanisms, that is, firstly a cassette inserter consisting of an unprocessed-wafer cassette (12a), a wafer inserter (13a) with a vacuum pad on the end of an arm and a processed-wafer cassette (12b) with a wafer inserter (13b) having a vacuum pad on the end of an arm, secondly a track system consisting of a roller track (11b) and a belt track (11a), thirdly a loading system consisting of a robotic loader (9) and a vacuum pad (9a), and fourthly a re-slicing system consisting of a movable mounting-block mechanism (10), a vacuum chuck (10a), a stationary slicing machine (7) having an ID saw (72). The mechanical function of each constituent element in the above is now described in detail as follows:

Firstly, this is a so-called "cassette-to-cassette system", that is, a plurality of unprocessed wafers (1) are first stored in the unprocessed-wafer cassette (12a) in Fig. 5. One piece of unprocessed wafer (1) is engaged on its lower surface by the inserter's vacuum pad and inserted on the roller track (11b) by the action of wafer inserter (13b) and it is relayed on the belt track (11a) to transfer it to a predetermined position for picking up. Wafer inserting action is limited, in that a processed wafer (1) is sent back through these track means (11a)(11b) after the completion of the re-slicing process, and is further inserted into the processed-wafer cassette (12b) by the wafer inserter (13b) with the vacuum pad applying to the underside of wafer (1).

As to the loading system, now the wafer (1) is positioned at a predetermined position on the belt track (11a). The loader's arm (9) with the vacuum pad (9a) bends down vertically in deep bow by means of the rotary mechanism (9c) and the vacuum pad (9a) positions on the top of the unprocessed wafer (1) with some clearance between them. The vacuum pad (9a) then descends and engages the unprocessed wafer (1) by means of a telescopic mechanism (9b), and the loader's arm (9) with the unprocessed wafer (1) swings up so as to place the unprocessed wafer (1) and the vacuum chuck (10a) in register by means of the rotary mechanism (9c). The telescopic mechanism (9b) actuates to press the unprocessed wafer (1) softly to the vacuum chuck (10a) of movable mounting-block mechanism (10). The unprocessed wafer (1) is held by the vacuum chuck (10a) securely and the suction of the vacuum pad (9a) of the robotic loader (9) is stopped temporarily during the re-slicing process. The robotic loader (9) remains at the same attitude after the delivery, and follows the upward movement of the movable mounting-block mechanism (10) while the vacuum pad (9a) is temporarily released, because the vacuum pad (9a) must later engage a section of the re-sliced wafer (1) at a desired time before the completion of re-slicing.

Upon the completion of re-slicing, the unprocessed wafer (1) has been re-sliced into two pieces of processed wafers (1)(1). In this regard, it is defined that a piece of processed wafer (1) is designated as a substrate (1a)(1b) hereinafer in the disclosure. Thus, now a substrate (1b) is held by the vacuum pad (9a) of the robotic loader (9) upon completion of re-slicing, and it is swung down to the belt track (11) as described previously for transportation. On the other hand, the other substrate (1a) remains on the vacuum chuck (10a) as it was after the release of substrate (1b) from the vacuum chuck (10a). The recovery of substrate (1a) will be described later in the re-slicing process.

Lastly, the re-slicing process and the apparatus are illustrated in Figs. 4 and 5. The re-slicing work is started at the point at which the unprocessed wafer (1) is delivered to the vacuum chuck (10a) of the movable mounting-block mechanism (10) from the robotic loader (9). Regarding, the relationship between the movable mounting-block mechanism (10) and the re-slicing machine (7), it is noted that the movable mounting-block mechanism (10) moves towards the ID saw of the re-slicing machine (7) which remains stationary. The mounting mechanism (10) is disposed perpendicularly to the re-slicing machine (7), and is movably driven by an elevating mechanism (not shown in the drawings).

Upon acceptance of the unprocessed wafer (1) from the robotic loader (9), the mounting block mechanism (10) with the wafer (1) starts to move upwardly while detecting the blade edge of ID saw (72), which is an annular shape and is held within a tension head (71), with the assistance of an automatic sizing machine so as to locate the approximate centre of the wafer's thickness. The blade edge of the ID saw has a blade core bonded with superhigh-hardness type abrasive grains such as an industrial diamond or the like, and rotates at an adequate speed. On the end of the mounting block mechanism (10), the vacuum chuck (10a) is disposed, and is made of a porous type ceramic or the like and communicates pneumatically with a vacuum pump through a vacuum passage. The mounting block mechanism (10) is arranged at a predetermined position with the centre of the opening of the ID saw as its referential level, and is elevated automatically. As shown by the double dot broken lines of Fig. 4, as the mounting block mechanism (10) is elevated the unprocessed wafer (1) (shown by a solid line) is re-sliced into two substrates (1a)(1b) (also shown by double dot broken lines). The substrate (1b) is engaged again by the vacuum pad (9a) which has followed continuously in response to the upward movement of the mounting block mechanism (10) with the unprocessed wafer (1) during the re-slicing work. On the way to the completion of re-slicing, the vacuum pad (9a) will begin vacuum action so as to engage the substrate (1b). The mounting block mechanism (10) with the substrate (1a) is then returned to the referential level and releases the second substrate (1a) to the vacuum pad (9a) of robotic loader (9), and the robotic loader (9) swings down to the belt track (11a) and releases the substrate (1a) onto the belt track (11a). The substrate (1a) is further transferred to the roller track (11b), relayed to the wafer inserter (13b) and finally stored away in the processed wafer cassette (12b). Upon acceptance of the substrate (1a), the processed wafer cassette (12b) will rise up slightly with a pitch equivalent to the thickness of one piece for acceptance of the next substrate. During the course of these actions in the downstream stages, the robotic loader (9) moves again for the next unprocessed wafer.

It will be recognized that there are other equivalent ways of achieving the process of the present invention. For example, it is envisaged that two systems of belt track (11a) may be provided in order to enhance the working speed of transportation although one belt track (11a) was used in the above practical example. In addition, it is also envisaged that two systems of robotic loader (9) for recovering the substrates (1a)(1b) may be provided for enhancing the working speed. Further, it is also envisaged that the relationship of movement between the movable mounting-block mechanism (10) and the re-slicing mechine (7) may be changed, that is to say, a stationary mounting-block mechanism (10) and a movable re-slicing machine (7).

In addition, another very important way will be described later specifically, relating to a practical example of the present invention. Conventionally, a slice base is attached to an Si-ingot prior to a slicing process in order to fix each sliced wafer, as a comb in side view, on its base (orientation flat) after slicing. After that, a number of wafers and the slice base are separated by means of a chemical solution.

In Figs. 7 and 8, however, we provide a wafer (1) having a chip of slice base (14) adhered subsequently but prior to the re-slicing process and in preparation therefor. That is, it provides a twin type substrate (1a) and (1b) adhered onto an orientation flat (10) on the chip (14′) after the completion of the re-slicing of the wafer shown in Figs. 8(A) and (B).

Referring now in detail to the above other example of the present invention. In contrast with the initial example, it is noted that a twin type substrate is obtainable and therefore a stationary robotic loader (9) may be used, because it is no longer necessary for the robotic loader (9) to move together with the movable mounting-block mechanism (10) for engaging a section (1b) of re-sliced wafer. Since the above two aspects are different from the initial example but the remaining features are the same, the same referential marks are written in the drawings Figs. 6 to 8 and any specific explanation for the remaining feature will be omitted hereinafter.

In Fig. 7 and Fig. 8, a slice base (14)(14′) is made from carbon, silicon or the like and the base (14) is adhered to an opposite edge of an orientation flat (1o), as in Fig. 7 or alternatively the base (14′) is adhered to the orientation flat (1o), as in Fig. 8. The adhesion of the base chip (14)(14′) to the unprocessed wafer (1) is performed automatically by mechatronics.

For re-slicing the unprocessed wafer (1) with the base chip (14)(14′), the centre of the wafer's thickness is detected first by an automatic sizing machine, and the unprocessed wafer (1) is re-sliced but the base chip (14)(14′) is not entirely sliced through so as to keep the twin substrates (1a) and (1b) attached to each other via the base chip (14)(14′). This feature is illustrated in Fig. 6. In the drawings, firstly the robotic loader (9) engages an unprocessed wafer (1) and swings up to deliver the wafer (1) to the vacuum chuck (10a). When the wafer (1) has been caught by the vacuum chuck (10a) securely, the vacuum action of vacuum pad (9a) of robotic loader (9) is stopped until the completion of re-slicing. The robotic loader (9) remains stationary and only the movable mounting-block mechanism (10) moves upwardly towards the ID saw to re-slice the wafer (1). This feature is illustrated by the two dot broken lines in Fig. 6.

The re-sliced wafers, that is, the twin substrates (1a)(1b) is held by the vacuum chuck (10a) intact and is returned to the original position where the robotic loader (9) is ready to engage it again, the stationary robotic loader (9) sending it backonto the belt track (11a) in its twin state.

This practical example shown in Figs. 6 to 8, is advantageous in that an unprocessed wafer (1) with a base chip (14)(14′) is re-sliced same distance from the bottom of the base chip, which can protect the wafer from end chipping damage which occurse sometime in slicing work, owing to the slice base adhered incorporatedly to the wafer. Whereby one can obtain high quality products, moreover a high productive yield and an improvement of productivity. In addition, since these substrates (1a)(1b) are incorporated as a twin on the slice base, the provision of two recovery systems in the transporter is not required, thereby simplifying the structure of the recovery means and its attachments.

In addition, the aforementioned practical examples refer to the processes for re-slicing a wafer from one end to the other end being achievable by mobilizing either the mounting-block mechanism or the re-slicing machine toward the up and down directions selectively. However, the mobilizing direction is not limited to the up and down directions but other directions such as an opblique direction, a horizontal direction or over a circular arcs direction are possible.

It is to be understood that the present invention is not limited in its application to the details of construction and arrangement of parts illustrated in the drawings.

## Claims

1. A process of making semiconductor wafer substrates (1a, 1b), characterised by bonding a slice base (14/14′) to an edge of a semiconductor wafer (1) having impurity diffused layers (2) at both main surfaces thereof and a core into which the impurity diffused layers do not extend, holding said wafer by at least one of said main surfaces, and slicing said wafer into two wafer substrates from an edge opposite to that to which said slice base is bonded along a plane parallel to both main surfaces of the wafer and approximately through the centre of the wafer by means of a slicing machine saw (72) rotating at a high speed, each of said wafer substrates having at one surface one of said impurity diffusion layers and at the other surface an impurity diffusion-free surface (5) which is formed to be suitable for doping.

2. A process according to claim 1 wherein said step of holding includes
holding said wafer by one of said main surfaces by a vacuum action and
holding said wafer by the other main surface by a vacuum action at least prior to completion of the slicing of said slice base.

3. A process according to claim 1, characterised in that said step of holding includes holding said wafer by only one of said main surfaces by a vacuum action during slicing of said wafer, and in that cutting occurs only partially into said slice base so as to maintain the attachment of the wafer substrates after the completion of slicing.

4. A process as claimed in any of claims 1 to 3, characterised in that the impurity of said impurity diffused layers consists of one or more of phosphor, boron, aluminium, gallium, arsenic and antimony.

5. A process as claimed in any of the preceding claims, characterised in that the said wafer is a silicon wafer with an approximate thickness of between 0.9 mm and 1.1 mm.

6. A process as claimed in any of the preceding claims, characterised in that the size of said wafer is between 5 cm and 15 cm in diameter.

7. A process as claimed in any of the preceding claims, characterised in that the thickness of each wafer substrate is between approximately 0.2mm and 0.35mm.

## Patentansprüche

1. Verfahren zum Herstellen von Halbleiter-Plättchensubstraten (1a, 1b), gekennzeichnet durch folgende Verfahrensschritte:
- Ein Schneidsockel (14/14′) wird an einem Rand eines Halbleiterplättchens (1) befestigt, welches an seinen beiden Hauptflächen Fremdatom-Diffusionsschichten (2) aufweist und einen Kern besitzt, in welchen sich die Fremdatom-Diffusionsschichten (2) nicht erstrecken;
- das Plättchen wird an zumindest einer der beiden Hauptflächen gehalten, und
- das Plättchen wird ausgehend von einem Rand, welcher dem mit dem Schneidsockel versehenen Rand gegenüberliegt, längs einer parallel zu den beiden Hauptflächen des Plättchens und ungefähr durch die Plättchenmitte verlaufenden Ebene mittels einer mit hoher Drehzahl rotierenden Schneidmaschinensäge (72) in zwei Plättchensubstrate zerteilt, wobei jedes der beiden Plättchensubstrate an seiner einen Oberfläche eine von beiden Fremdatom-Diffusionsschichten und an seiner anderen Oberfläche eine von diffundierten Fremdatomen freie Fläche (5) aufweist, welche für Dotierungszwecke gebildet wird.

2. Verfahren nach Anspruch 1, wobei zum Halten des Plättchens eine der beiden Hauptflächen des Plättchens mittels Saugwirkung gehalten wird und die andere Hauptfläche des Plättchens zumindest vor Beendigung der Zerteilung des Schneidsockels durch Saugwirkung gehalten wird.

3. Verfahren nach Anspruch 1, **dadurch gekennzeichnet,** daß zum Halten des Plättchens nur eine der beiden Hauptflächen des Plättchens mittels Saugwirkung während der Zerteilung des Plättchens gehalten wird, und daß die Zerteilung nur teilweise in dem Schneidsockel erfolgt, um die Befestigung der Plättchensubstrate nach Beendigung der Zerteilung zu erhalten.

4. Verfahren nach einem der Ansprüche 1 bis 3, **dadurch gekennzeichnet**, daß für die Fremdatome der Fremdatom-Diffusionsschichten ein Element oder mehrere Elemente aus der Gruppe Phosphor, Bor, Aluminium, Gallium, Arsen und Antimon vorgesehen wird.

5. Verfahren nach einem der vorhergehenden Ansprüche, **dadurch gekennzeichnet**, daß als Plättchen ein Silizium-Plättchen mit einer ungefähren Dicke zwischen 0,9 mm und 1,1 mm vorgesehen wird.

6. Verfahren nach einem der vorhergehenden Ansprüche, **dadurch gekennzeichnet**, daß die Größe des Plättchens zwischen 5 cm und 15 cm im Durchmesser beträgt.

7. Verfahren nach einem der vorhergehenden Ansprüche, **dadurch gekennzeichnet**, daß die Dicke jedes Plättchen-Substrates im Bereich zwischen etwa 0,2 mm und 0.35 mm liegt.

## Revendications

1. Procédé de fabrication de substrats de plaquette de semiconducteur (1a, 1b), caractérisé par la liaison d'une base de plaquette (14/14′) à un bord d'une plaquette semiconductrice (1) ayant des couches de diffusion d'impuretés (2) sur ses deux faces principales et un coeur dans lequel ne pénètrent pas les couches de diffusion d'impuretés; le maintien de ladite plaquette par au moins une desdites faces principales et le découpage de ladite plaquette en deux substrats à partir du bord opposé à celui auquel ladite base de plaquette est reliée, le long d'un plan parallèle aux deux faces principales de la plaquette et passant approximativement par le milieu de la plaquette, au moyen d'une scie (72) de machine à découper tournant à grande vitesse, chacun desdits substrats ayant, sur une face, une desdites couches de diffusion d'impuretés et, sur l'autre face, une surface sans diffusion d'impuretés (5) qui est formée pour convenir au dopage.

2. Procédé suivant la revendication 1, dans lequel ladite phase de maintien comprend
le maintien de ladite plaquette par une desdites faces principales par action du vide, et
le maintien de ladite plaquette par l'autre face principale par action du vide, au moins avant de terminer le découpage de ladite base de plaquette.

3. Procédé suivant la revendication 1, caractérisé en ce que ladite phase de maintien comprend le maintien de ladite plaquette par seulement une desdites faces principales par une action de vide pendant le découpage de ladite plaquette et en ce que le découpage ne se fait que partiellement dans ladite base de plaquette de façon à maintenir l'attache des substrats après la fin du découpage.

4. Procédé suivant l'une des revendications 1 à 3, caractérisé en ce que l'impureté desdites couches de diffusion d'impuretés consiste en un ou plusieurs corps simples comprenant le phosphore, le bore, l'aluminium, le gallium, l'arsenic et l'antimoine.

5. Procédé suivant l'une des revendications précédentes, caractérisé en ce que ladite plaquette est une plaquette de silicium ayant une épaisseur d'environ 0,9 à 1,1 mm.

6. Procédé suivant l'une des revendications précédentes, caractérisé en ce que la dimension du diamètre de ladite plaquette est comprise entre 5 et 15 cm.

7. Procédé suivant l'une des revendications précédentes, caractérisé en ce que l'épaisseur de chaque substrat de plaquette est d'environ 0,2 à 0,35 mm.
